# EUROPEAN PATENT APPLICATION

(11) **EP 3 547 477 A1**
(43) Date of publication of application: **02.10.2019**
(21) Application number: 18713784.9
(22) Date of filing: 09.03.2018
(51) Int. Cl.: H02H 9/04

(54) **SAFETY ELECTRONIC SWITCH**

(30) Priority: 05.02.2018 CN 201810111642
(71) Applicant: G-Technology Co., Ltd., East District Zhongshan Guangdong 528404 (CN)
(72) Inventor: MO, Li, Zhongshan, Guangdong 528404 (CN); LI, Zhi jun, Zhongshan, Guangdong 528404 (CN); LIN, Wenfeng, Zhongshan, Guangdong 528404 (CN); ZHU, Jinpeng, Zhongshan, Guangdong 528404 (CN)
(74) Representative: Heilein, Ernst - Peter
(86) International application number: PCT/CN2018/078592
(87) International publication number: WO 2019/148589

(57) **Abstract**

The present invention discloses a safety electronic switch, comprising: a first terminal, a second terminal, a third terminal, a surge voltage suppression unit, a comparator, and a relay. The surge voltage suppression unit is connected to a safety circuit through the first terminal. The first terminal is provided with a live wire end and a neutral wire end. The surge voltage suppression unit is connected to the comparator. The comparator is connected to the relay. The relay is connected to the second terminal and the third terminal. The third terminal is connected to a low-voltage power supply. The third terminal is provided with a positive electrode and a negative electrode that are connected to the low-voltage power supply. In the present invention, a surge voltage suppression unit is used to enhance the anti-interference capability of an input terminal, thereby ensuring the reliability of operation in a complex electromagnetic environment. In addition, a threshold voltage is designed through the comparator, so as to reduce the influence of input voltage fluctuation on the circuit. The dual-channel output structure is adopted to meet the requirements of a functional safety level SIL3. PhotoMOS optoelectronic couplers are used, so that the requirements of safety electric isolation are satisfied.

## Description

### TECHNICAL FIELD

The present invention relates to the field of elevator control, and in particular, to a safety electronic switch.

### BACKGROUND

An elevator is a motor-powered vertical lift with a box-shaped car for carrying people or goods in a multi-story building. In modern society, elevators have become indispensable transport devices which facilitate transportation in tall buildings. As the operation of an elevator involves personal safety, in order to ensure the safe operation of the elevator, many safety components such as a speed limiter, a safety gear, an emergency stop button, an emergency exit switch, a pit switch, and a limit switch are respectively mounted in various parts for operation and control. The contacts of the foregoing safety components are connected to relays or contactors in series to form a safety circuit of the elevator. The elevator can operate only when each safety component in the safety circuit of the elevator is normal, otherwise the elevator will stop running immediately.

In current elevator regulations, it is required that a running contactor should be connected in series between a frequency converter and a motor. The running contactor is controlled by a safety circuit. However, in actual application, the running contactor has problems of large volume, noise during operation, limited mechanical life, and high prices. At present, a frequency converter having the Safe Torque Off (STO) function has been developed outside China. It is proved according to tests by a certification authority in Germany that when such a frequency converter having the STO function is used, the elevator control is safe even if the running contactor between the frequency converter and the motor is omitted. In Germany, frequency converters having the STO function have been able to pass the safety certification of certification authorities. In China, the safety of frequency converters having the STO function have already been being studied. In the near future, the running contactor will be omitted as has been done in foreign countries, which will be the development trend in the elevator industry.

A safety electronic switch is configured to be connected between the safety circuit of the elevator and the frequency converter with STO and is a key device for achieving safe operation without the running contactor. Current products commercially available having similar functions have the problem of low surge protection capability and fail to satisfy the requirements of safe electrical isolation. In addition, common safety electronic switches commercially available use safety relays which have the problems of high prices, noise during operation, and relatively short service life.

### SUMMARY

To resolve the foregoing problems, the present invention provides a safety electronic switch which has a high surge protection capability and satisfies the requirements of safe electrical isolation. It is used between a safety circuit and a frequency converter that has an STO function, so as to eventually realize the safe operation of an elevator control system without a running contactor.

The present invention adopts the following technical solution:
A safety electronic switch, disposed between a safety circuit and a frequency converter and connected to an external low-voltage power supply to supply power, comprises: a first terminal, a second terminal, a third terminal, a surge voltage suppression unit (SVSU), a comparator, and a relay, wherein an input terminal of the surge voltage suppression unit is connected to the safety circuit through the first terminal, the first terminal is provided with a live wire end and a neutral wire end, an output terminal of the surge voltage suppression unit is connected to an input terminal of the comparator, an output terminal of the comparator is connected to the relay, the relay is connected to the second terminal and the third terminal, respectively, the second terminal is connected to the frequency converter, the third terminal is connected to the low-voltage power supply, and the third terminal is provided with a positive electrode and a negative electrode that are connected to the low-voltage power supply.

Further, the surge voltage suppression unit comprises a transient voltage suppressor D4 and a transient voltage suppressor D10;
one end of the transient voltage suppressor D4 is connected to the live wire end of the first terminal through a resistor R3 and a resistor R4 that are sequentially connected in series, and the other end of the transient voltage suppressor D4 is connected to the neutral wire end of the first terminal; and
one end of the transient voltage suppressor D10 is connected to the live wire end of the first terminal through a resistor R14 and a resistor R13 that are sequentially connected in series, and the other end of the transient voltage suppressor D10 is connected to the neutral wire end of the first terminal.

Further, a resistor R7 is connected in parallel across the transient voltage suppressor D4, and a resistor R8 is disposed between the transient voltage suppressor D4 and the neutral wire end of the first terminal; and a resistor R17 is connected in parallel across the transient voltage suppressor D10, and a resistor R18 is disposed between the transient voltage suppressor D10 and the neutral wire end of the first terminal.

Further, the comparator comprises a first comparator and a second comparator, the first comparator comprises a comparator U2A and a comparator U2B, the second comparator comprises a comparator U4A and a comparator U4B, an anti-phase input terminal of the comparator U2A is connected to an anti-phase input terminal of the comparator U2B, an in-phase input terminal of the comparator U2A is connected to an in-phase input terminal of the comparator U2B, an anti-phase input terminal of the comparator U4A is connected to an anti-phase input terminal of the comparator U4B, and an in-phase input terminal of the comparator U4A is connected to an in-phase input terminal of the comparator U4B;
a dual switching diode D3, a dual switching diode D6, a Zener diode D2, and a Zener diode D5 are disposed between the comparator U2A and the transient voltage suppressor D4; an output terminal of the comparator U2A is connected to a positive electrode of the Zener diode D2 and a negative electrode of the Zener diode D5, a negative electrode of the Zener diode D2 is connected to a negative electrode of the dual switching diode D3 and a negative electrode of the dual switching diode D6 through a resistor R2, an intermediate contact of the dual switching diode D3 is connected to a common terminal of the transient voltage suppressor D4 and the resistor R4, a capacitor C1 and a capacitor C2 are connected in parallel between a positive electrode and the negative electrode of the dual switching diode D3, a positive electrode of the Zener diode D5 is connected to a positive electrode of the dual switching diode D6 and the positive electrode of the dual switching diode D3, and an intermediate contact of the dual switching diode D6 is connected to the other end of the transient voltage suppressor D4; and a V+ terminal of the comparator U2A is connected to the negative electrode of the dual switching diode D3, the V+ terminal of the comparator U2A and a V+ terminal of the comparator U2B are both connected to a VCC1 terminal of the low-voltage power supply, a V- terminal of the comparator U2A is connected to the positive electrode of the dual switching diode D3 and the positive electrode of the dual switching diode D6, and the V- terminal of the comparator U2A and a V- terminal of the comparator U2B are both connected to a negative terminal of the capacitor C1; and
a dual switching diode D9, a dual switching diode D12, a Zener diode D8, and a Zener diode D11 are disposed between the comparator U4A and the transient voltage suppressor D10, an output terminal of the comparator U4A is connected to a positive electrode of the Zener diode D8 and a negative electrode of the Zener diode D11, a negative electrode of the Zener diode D8 is connected to a negative electrode of the dual switching diode D9 and a negative electrode of the dual switching diode D12 through a resistor R12, an intermediate contact of the dual switching diode D9 is connected to a common terminal of the transient voltage suppressor D4 and the resistor R14, a positive electrode of the Zener diode D11 is connected to a positive electrode of the dual switching diode D12 and a positive electrode of the dual switching diode D9, and an intermediate contact of the dual switching diode D12 is connected to the other end of the transient voltage suppressor D10; and a capacitor C5 and a capacitor C6 are connected in parallel between the positive electrode and the negative electrode of the dual switching diode D9, a V+ terminal of the comparator U4A is connected to the negative electrode of the dual switching diode D9, the V+ terminal of the comparator U4A and a V+ terminal of the comparator U4B are both connected to a VCC2 terminal of the low-voltage power supply, a V-terminal of the comparator U4B is connected to the positive electrode of the dual switching diode D9 and the positive electrode of the dual switching diode D12, and a V- terminal of the comparator U4A and the V- terminal of the comparator U4B are both connected to a negative terminal of the capacitor C5.

Further, a common contact of the in-phase input terminal of the comparator U2A and the in-phase input terminal of the comparator U2B is connected to the positive electrode of the Zener diode D5 through a resistor R9, and the common contact of the in-phase input terminal of U2A and the in-phase input terminal of the comparator U2B is connected to the negative electrode of the Zener diode D2 through a resistor R6; and a common contact of the anti-phase input terminal of the comparator U2A and the anti-phase input terminal of the comparator U2B is connected to the positive electrode of the Zener diode D5 through a resistor R10, the common contact of the anti-phase input terminal of the comparator U2A and the anti-phase input terminal of the comparator U2B is connected to the V+ terminal of the comparator U2A through a resistor R5, the common contact of the anti-phase input terminal of the comparator U2A and the anti-phase input terminal of the comparator U2B is connected to the V- terminal of the comparator U2A through a capacitor C4, and the V+ terminal of the comparator U2B is connected to the V- terminal of the comparator U2B through a capacitor C3; and
a common contact of the in-phase input terminal of the comparator U4A and the in-phase input terminal of the comparator U4B is connected to the positive electrode of the Zener diode D11 through a resistor R19, and the common contact of the in-phase input terminal of U4A and the in-phase input terminal of the comparator U4B is connected to the negative electrode of the Zener diode D8 through a resistor R16; and a common contact of the anti-phase input terminal of the comparator U4A and the anti-phase input terminal of the comparator U4B is connected to the positive electrode of the Zener diode D11 through a resistor R20, the common contact of the anti-phase input terminal of the comparator U4A and the anti-phase input terminal of the comparator U4B is connected to the V+ terminal of the comparator U4A through a resistor R15, the common contact of the anti-phase input terminal of the comparator U4A and the anti-phase input terminal of the comparator U4B is connected to the V- terminal of the comparator U4A through a capacitor C8, and the V+ terminal of the comparator U4B is connected to the V- terminal of the comparator U4B through a capacitor C7.

Further, the relay is selected as a PhotoMOS optoelectronic coupler, comprising a PhotoMOS optoelectronic coupler U1 and a PhotoMOS optoelectronic coupler U3, an STOA pin and an STOB pin connected to the frequency converter and used for dual outputs are disposed on the second terminal, and the third terminal is provided with the positive electrode and the negative electrode that are connected to the low-voltage power supply.

A pin 4 of the PhotoMOS optoelectronic coupler U1 is connected to an output terminal of the comparator U2B, a pin 2 of the PhotoMOS optoelectronic coupler U1 is connected to a pin 3 of the PhotoMOS optoelectronic coupler U1, a pin 1 of the PhotoMOS optoelectronic coupler U1 is connected to the V+ terminal of the comparator U2B through a switching diode D1 and a resistor R1 that are sequentially connected in series, the pin 1 of the PhotoMOS optoelectronic coupler U1 is connected to a negative electrode of the switching diode D1, a positive electrode of the switching diode D1 is connected to the resistor R1, a pin 8 of the PhotoMOS optoelectronic coupler U1 is connected to the positive electrode of the third terminal, a pin 7 of the PhotoMOS optoelectronic coupler U1 is connected to a pin 6 of the PhotoMOS optoelectronic coupler U1, a pin 5 of the PhotoMOS optoelectronic coupler U1 is connected to the STOB pin of the second terminal, the pin 5 of the PhotoMOS optoelectronic coupler U1 is connected to the pin 8 of the PhotoMOS optoelectronic coupler U1 through a capacitor CY1, the pin 5 of the PhotoMOS optoelectronic coupler U1 is connected to a negative electrode of the second terminal through a resistor R21 and a light-emitting diode LED1 that are sequentially connected in series, a positive electrode of the light-emitting diode LED1 is connected to the resistor R21, a negative electrode of the light-emitting diode LED1 is connected to the negative electrode of the second terminal, a diode D15 is connected in parallel across the light-emitting diode LED1, the positive electrode of the light-emitting diode LED1 is connected to a negative electrode of the diode D15, and the negative electrode of the light-emitting diode LED1 is connected to a positive electrode of the diode D15; and
a pin 4 of the PhotoMOS optoelectronic coupler U3 is connected to an output terminal of the comparator U4B, a pin 2 of the PhotoMOS optoelectronic coupler U3 is connected to a pin 3 of the PhotoMOS optoelectronic coupler U3, a pin 1 of the PhotoMOS optoelectronic coupler U3 is connected to the V+ terminal of the comparator U4B through a switching diode D7 and a resistor R11 that are sequentially connected in series, the pin 1 of the PhotoMOS optoelectronic coupler U3 is connected to a negative electrode of the switching diode D7, a positive electrode of the switching diode D7 is connected to the resistor R11, a pin 8 of the PhotoMOS optoelectronic coupler U3 is connected to the positive electrode of the third terminal, a pin 7 of the PhotoMOS optoelectronic coupler U3 is connected to a pin 6 of the PhotoMOS optoelectronic coupler U3, a pin 5 of the PhotoMOS optoelectronic coupler U3 is connected to the STOA pin of the second terminal, the pin 5 of the PhotoMOS optoelectronic coupler U3 is connected to the pin 8 of the PhotoMOS optoelectronic coupler U3 through a capacitor CY2, the pin 5 of the PhotoMOS optoelectronic coupler U3 is connected to the negative electrode of the second terminal through a resistor R22 and the light-emitting diode LED2 that are sequentially connected in series, a positive electrode of the light-emitting diode LED2 is connected to the resistor R22, a negative electrode of the light-emitting diode LED2 is connected to the negative electrode of the second terminal, a diode D16 is connected in parallel across the light-emitting diode LED2, the positive electrode of the light-emitting diode LED2 is connected to a negative electrode of the diode D16, and the negative electrode of the light-emitting diode LED2 is connected to a positive electrode of the diode D16.

Further, a diode D13, a transient voltage suppressor D14, and a diode D17 that are sequentially connected in series are disposed between the positive electrode and the negative electrode of the third terminal, the positive electrode of the third terminal is connected to a positive electrode of the diode D13, a negative electrode of the diode D13 is connected to a negative electrode of the transient voltage suppressor D14, a positive electrode of the transient voltage suppressor D14 is connected to a positive electrode of the diode D17, and a negative electrode of the diode D17 is connected to the negative electrode of the third terminal; and a common terminal of the diode D13 and the transient voltage suppressor D14 is connected to a positive electrode of the low-voltage power supply.

Further, the live wire end of the first terminal is set to be a pin 1, and the neutral wire end is set to be a pin 4; and the positive electrode of the third terminal is set to be a pin 2, and the negative electrode is set to be a pin 3.

Further, the STOB pin of the second terminal is set to be a pin 1, the STOA pin is set to be a pin 3, a negative electrode of a low voltage power supply and a PE pin are further comprised, the negative electrode of the low voltage power supply is set to be a pin 2, and the PE pin is set to be a pin 4.

A flame-retardant housing and a flame-retardant PCB board disposed inside the flame-retardant housing are further comprised, the first terminal, the second terminal, the third terminal, the surge voltage suppression unit, the comparator, and the relay are all packaged on the flame-retardant PCB board, and the resistor R3, the resistor R4, the resistor R13, and the resistor R14 are all selected as cement resistor.

Beneficial effects of the present invention are as follows:
In the present invention, a first terminal is used as an input terminal to be connected to a safety circuit of a control system, a second terminal is used as an output terminal to be connected to a frequency converter of an elevator, and a surge voltage suppression unit is used to enhance the anti-interference capability of an input terminal, thereby ensuring the reliability of operation in a complex electromagnetic environment. In addition, the influence of input voltage fluctuation on the circuit is reduced by designing a threshold voltage through a comparator. The dual-channel output structure is adopted to meet the requirements of a functional safety level SIL3. PhotoMOS optoelectronic couplers are used, which can not only meet the requirements of safety electric isolation, but also operate without noise and have a long service life. The input energy, and therefore the maximum input power, is limited by using a high input impedance, thereby effectively limiting the temperature rise of the safety electronic switch, and improving the flame-retardancy of a product. In addition, the terminals with a fault-tolerant design can effectively prevent the product from being damaged due to wiring errors during installation.

### BRIEF DESCRIPTION OF THE DRAWINGS

The specific embodiments of the present invention are further described below with reference to the accompanying drawings, wherein:
FIG. 1 is an electrical principle diagram of a safety electronic switch according to the present invention;
FIG. 2 is a circuit diagram of the safety electronic switch according to the present invention;
FIG. 3 is a pin diagram of a second terminal according to the present invention; and
FIG. 4 is a circuit diagram of connection of a third terminal to a SELV power supply according to the present invention.

### DETAILED DESCRIPTION OF THE EMBODIMENTS

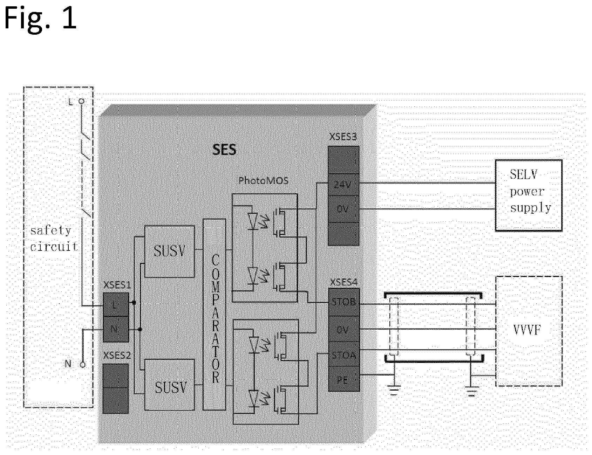

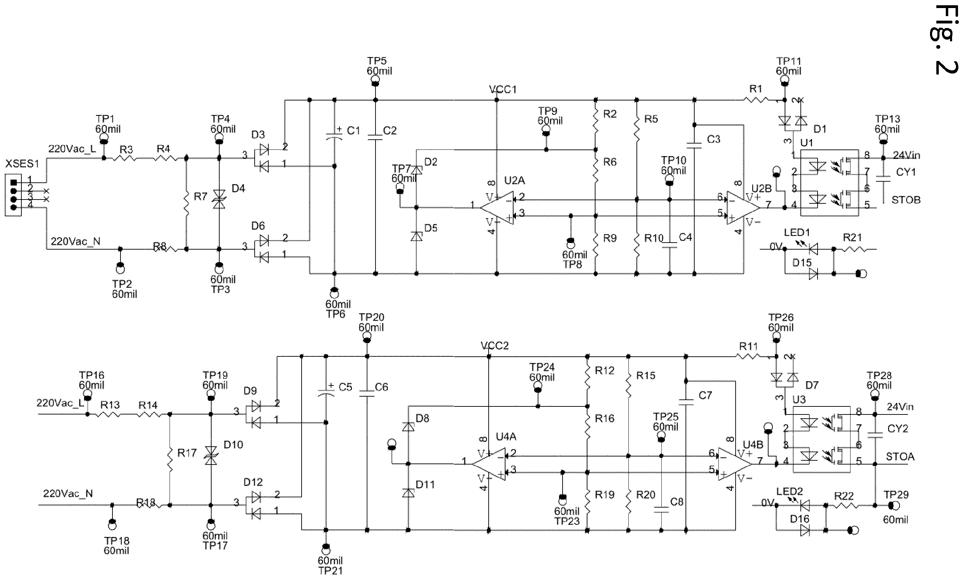

FIG. 1 and FIG. 2 show a safety electronic switch of the present invention which is disposed between a safety circuit and a frequency converter. The safety electronic switch is connected to an external SELV (safe extra-low voltage) power supply to supply power, and comprises: a first terminal XSES1, a second terminal XSES4, a third terminal XSES3, a surge voltage suppression unit, a comparator, and a relay. The surge voltage suppression unit is connected to the safety circuit through the first terminal XSES1. The first terminal XSES1 is provided with a live wire end and a neutral wire end. The surge voltage suppression unit is connected to the comparator. The comparator is connected to the relay. The relay is connected to the second terminal XSES4 and the third terminal XSES3. The third terminal XSES3 is connected to the low-voltage power supply. The third terminal XSES3 is provided with a positive electrode and a negative electrode that are connected to the low-voltage power supply. A terminal XSES2 is reserved for use.

The surge voltage suppression unit comprises a transient voltage suppressor D4 and a transient voltage suppressor D10. One end of the transient voltage suppressor D4 is connected to the live wire end of the first terminal XSES1 through a resistor R3 and a resistor R4 that are sequentially connected in series, and the other end of the transient voltage suppressor D4 is connected to the neutral wire end of the first terminal XSES1. One end of the transient voltage suppressor D10 is connected to the live wire end of the first terminal XSES1 through a resistor R14 and a resistor R13 that are sequentially connected in series, and the other end of the transient voltage suppressor D10 is connected to the neutral wire end of the first terminal XSES1. A resistor R7 is connected in parallel across the transient voltage suppressor D4, and a resistor R8 is disposed between the transient voltage suppressor D4 and the neutral wire end of the first terminal XSES1. A resistor R17 is connected in parallel across the transient voltage suppressor D10, and a resistor R18 is disposed between the transient voltage suppressor D10 and the neutral wire end of the first terminal XSES1.

In this embodiment, the comparator comprises a first comparator and a second comparator, the first comparator comprises a comparator U2A and a comparator U2B, the second comparator comprises a comparator U4A and a comparator U4B, an anti-phase input terminal of the comparator U2A is connected to an anti-phase input terminal of the comparator U2B, an in-phase input terminal of the comparator U2A is connected to an in-phase input terminal of the comparator U2B, an anti-phase input terminal of the comparator U4A is connected to an anti-phase input terminal of the comparator U4B, and an in-phase input terminal of the comparator U4A is connected to an in-phase input terminal of the comparator U4B.

A dual switching diode D3, a dual switching diode D6, a Zener diode D2, and a Zener diode D5 are disposed between the comparator U2A and the transient voltage suppressor D4. An output terminal of the comparator U2A is connected to a positive electrode of the Zener diode D2 and a negative electrode of the Zener diode D5, a negative electrode of the Zener diode D2 is connected to a negative electrode of the dual switching diode D3 and a negative electrode of the dual switching diode D6 through a resistor R2, an intermediate contact of the dual switching diode D3 is connected to a common terminal of the transient voltage suppressor D4 and the resistor R4, a capacitor C1 and a capacitor C2 are connected in parallel between a positive electrode and the negative electrode of the dual switching diode D3, a positive electrode of the Zener diode D5 is connected to a positive electrode of the dual switching diode D6 and the positive electrode of the dual switching diode D3, and an intermediate contact of the dual switching diode D6 is connected to the other end of the transient voltage suppressor D4. A V+ terminal of the comparator U2A is connected to the negative electrode of the dual switching diode D3, the V+ terminal of the comparator U2A and a V+ terminal of the comparator U2B are both connected to a VCC1 terminal of the low-voltage power supply, a V- terminal of the comparator U2A is connected to the positive electrode of the dual switching diode D3 and the positive electrode of the dual switching diode D6, and the V- terminal of the comparator U2A and a V- terminal of the comparator U2B are both connected to a negative terminal of the capacitor C1.

A dual switching diode D9, a dual switching diode D12, a Zener diode D8, and a Zener diode D11 are disposed between the comparator U4A and the transient voltage suppressor D10, an output terminal of the comparator U4A is connected to a positive electrode of the Zener diode D8 and a negative electrode of the Zener diode D11, a negative electrode of the Zener diode D8 is connected to a negative electrode of the dual switching diode D9 and a negative electrode of the dual switching diode D12 through a resistor R12, an intermediate contact of the dual switching diode D9 is connected to a common terminal of the transient voltage suppressor D4 and the resistor R14, a positive electrode of the Zener diode D11 is connected to a positive electrode of the dual switching diode D12 and a positive electrode of the dual switching diode D9, and an intermediate contact of the dual switching diode D12 is connected to the other end of the transient voltage suppressor D10. A capacitor C5 and a capacitor C6 are connected in parallel between the positive electrode and the negative electrode of the dual switching diode D9, a V+ terminal of the comparator U4A is connected to the negative electrode of the dual switching diode D9, the V+ terminal of the comparator U4A and a V+ terminal of the comparator U4B are both connected to a VCC2 terminal of the low-voltage power supply, a V- terminal of the comparator U4B is connected to the positive electrode of the dual switching diode D9 and the positive electrode of the dual switching diode D12, and a V- terminal of the comparator U4A and the V- terminal of the comparator U4B are both connected to a negative terminal of the capacitor C5.

A common contact of the in-phase input terminal of the comparator U2A and the in-phase input terminal of the comparator U2B is connected to the positive electrode of the Zener diode D5 through a resistor R9, and the common contact of the in-phase input terminal of U2A and the in-phase input terminal of the comparator U2B is connected to the negative electrode of the Zener diode D2 through a resistor R6. A common contact of the anti-phase input terminal of the comparator U2A and the anti-phase input terminal of the comparator U2B is connected to the positive electrode of the Zener diode D5 through a resistor R10, the common contact of the anti-phase input terminal of the comparator U2A and the anti-phase input terminal of the comparator U2B is connected to the V+ terminal of the comparator U2A through a resistor R5, the common contact of the anti-phase input terminal of the comparator U2A and the anti-phase input terminal of the comparator U2B is connected to the V- terminal of the comparator U2A through a capacitor C4, and the V+ terminal of the comparator U2B is connected to the V- terminal of the comparator U2B through a capacitor C3.

A common contact of the in-phase input terminal of the comparator U4A and the in-phase input terminal of the comparator U4B is connected to the positive electrode of the Zener diode D11 through a resistor R19, and the common contact of the in-phase input terminal of U4A and the in-phase input terminal of the comparator U4B is connected to the negative electrode of the Zener diode D8 through a resistor R16. A common contact of the anti-phase input terminal of the comparator U4A and the anti-phase input terminal of the comparator U4B is connected to the positive electrode of the Zener diode D11 through a resistor R20, the common contact of the anti-phase input terminal of the comparator U4A and the anti-phase input terminal of the comparator U4B is connected to the V+ terminal of the comparator U4A through a resistor R15, the common contact of the anti-phase input terminal of the comparator U4A and the anti-phase input terminal of the comparator U4B is connected to the V- terminal of the comparator U4A through a capacitor C8, and the V+ terminal of the comparator U4B is connected to the V- terminal of the comparator U4B through a capacitor C7.

To achieve a better muting and stabilizing effect, in this embodiment, the relay is selected as a PhotoMOS optoelectronic coupler, comprising a PhotoMOS optoelectronic coupler U1 and a PhotoMOS optoelectronic coupler U3. An STOA pin and an STOB pin connected to the frequency converter and used for dual outputs are disposed on the second terminal XSES4. The third terminal XSES3 is provided with the positive electrode and the negative electrode that are connected to the low-voltage power supply.

A pin 4 of the PhotoMOS optoelectronic coupler U1 is connected to an output terminal of the comparator U2B, a pin 2 of the PhotoMOS optoelectronic coupler U1 is connected to a pin 3 of the PhotoMOS optoelectronic coupler U1, and a pin 1 of the PhotoMOS optoelectronic coupler U1 is connected to the V+ terminal of the comparator U2B through a switching diode D1 and a resistor R1 that are sequentially connected in series, the pin 1 of the PhotoMOS optoelectronic coupler U1 is connected to a negative electrode of the switching diode D1, a positive electrode of the switching diode D1 is connected to the resistor R1, a pin 8 of the PhotoMOS optoelectronic coupler U1 is connected to the positive electrode of the third terminal XSES3, a pin 7 of the PhotoMOS optoelectronic coupler U1 is connected to a pin 6 of the PhotoMOS optoelectronic coupler U1, a pin 5 of the PhotoMOS optoelectronic coupler U1 is connected to the STOB pin of the second terminal XSES4, the pin 5 of the PhotoMOS optoelectronic coupler U1 is connected to the pin 8 of the PhotoMOS optoelectronic coupler U1 through a capacitor CY1, the pin 5 of the PhotoMOS optoelectronic coupler U1 is connected to a negative electrode of the second terminal XSES4 through a resistor R21 and a light-emitting diode LED1 that are sequentially connected in series, a positive electrode of the light-emitting diode LED1 is connected to the resistor R21, a negative electrode of the light-emitting diode LED1 is connected to the negative electrode of the second terminal XSES4, a diode D15 is connected in parallel acrose the light-emitting diode LED1, the positive electrode of the light-emitting diode LED1 is connected to a negative electrode of the diode D15, and the negative electrode of the light-emitting diode LED1 is connected to a positive electrode of the diode D15.

A pin 4 of the PhotoMOS optoelectronic coupler U3 is connected to an output terminal of the comparator U4B, a pin 2 of the PhotoMOS optoelectronic coupler U3 is connected to a pin 3 of the PhotoMOS optoelectronic coupler U3, a pin 1 of the PhotoMOS optoelectronic coupler U3 is connected to the V+ terminal of the comparator U4B through a switching diode D7 and a resistor R11 that are sequentially connected in series, the pin 1 of the PhotoMOS optoelectronic coupler U3 is connected to a negative electrode of the switching diode D7, a positive electrode of the switching diode D7 is connected to the resistor R11, a pin 8 of the PhotoMOS optoelectronic coupler U3 is connected to the positive electrode of the third terminal XSES3, a pin 7 of the PhotoMOS optoelectronic coupler U3 is connected to a pin 6 of the PhotoMOS optoelectronic coupler U3, a pin 5 of the PhotoMOS optoelectronic coupler U3 is connected to the STOA pin of the second terminal XSES4, the pin 5 of the PhotoMOS optoelectronic coupler U3 is connected to the pin 8 of the PhotoMOS optoelectronic coupler U3 through a capacitor CY2, the pin 5 of the PhotoMOS optoelectronic coupler U3 is connected to the negative electrode of the second terminal XSES4 through a resistor R22 and the light-emitting diode LED2 that are sequentially connected in series, a positive electrode of the light-emitting diode LED2 is connected to the resistor R22, a negative electrode of the light-emitting diode LED2 is connected to the negative electrode of the second terminal XSES4, a diode D16 is connected in parallel across the light-emitting diode LED2, the positive electrode of the light-emitting diode LED2 is connected to a negative electrode of the diode D16, and the negative electrode of the light-emitting diode LED2 is connected to a positive electrode of the diode D16.

Preferably, in this embodiment, the PhotoMOS optoelectronic couplers U1, U3 are both that with model VOR2142B8T. The first and second comparators are both that with model LM2903VQDR. The transient voltage suppressors D4, D10 are both that with model SMBJ18CA. The dual switching diodes D3, D6, D9, D12, D1, D7 are all that with model MMBD7000. Certainly, the protection scope of the present invention is not limited to the foregoing designated components.

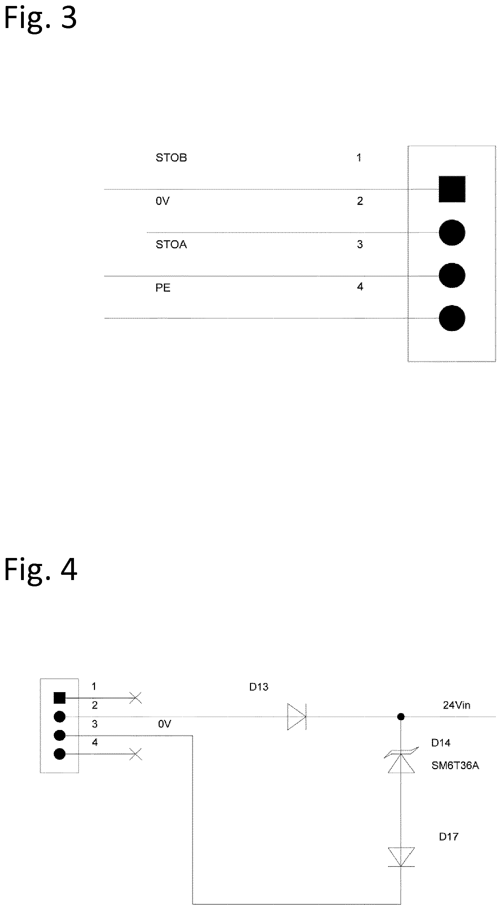

In the present invention, the same model is used for the terminals XSES1 to XSES4. To avoid wiring errors during installation, the safety electronic switch uses a fault-tolerant design. As shown in FIG. 2 to FIG. 4, the live wire end of the first terminal XSES1 is set to be a pin 1, and the neutral wire end is set to be pin 4. The positive electrode of the third terminal XSES3 is set to be a pin 2, and the negative electrode is set to be a pin 3. The STOB pin of the second terminal XSES4 is set to be a pin 1, and the STOA pin is set to be a pin 3. The pin 2 and pin 4 of the first terminal XSES1 are reserved, and the pin 1 and pin 4 of the third terminal XSES3 are reserved. Therefore, even if the first terminal XSES1 and the third terminal XSES3 are incorrectly plugged, the product will not be damaged. Similarly, even if the first terminal XSES1 and the second terminal XSES4 are incorrectly plugged, the product will not be damaged.

In addition, a diode D13, a transient voltage suppressor D14, and a diode D17 that are sequentially connected in series are disposed between the positive electrode and the negative electrode of the third terminal XSES3. The positive electrode of the third terminal XSES3 is connected to a positive electrode of the diode D13, a negative electrode of the diode D13 is connected to a negative electrode of the transient voltage suppressor D14, a positive electrode of the transient voltage suppressor D14 is connected to a positive electrode of the diode D17, and a negative electrode of the diode D17 is connected to the negative electrode of the third terminal XSES3. A common terminal of the diode D13 and the transient voltage suppressor D14 is connected to a positive electrode of the low-voltage power supply. The diode D17 acts as a reverse isolation of a 24V power supply. Even if the third terminal XSES3 and the second terminal XSES4 are incorrectly plugged, a current loop is not formed in the SELV power supply, and therefore the product will not be damaged either.

To improve the flame-retardancy of a product, in this embodiment, the PCB board, the terminals, and the housing are all made of flame-retardant materials, and the resistors R3, R4, R13, and R14 that are directly connected to the safety circuit are all selected as cement resistor. The line width between circuit components inside the safety electronic switch is 60 mils so as to increase the upper limit of temperature rise.

The working procedure of the present invention:
In the present invention, the first terminal XSES1 is connected to a safety circuit of a control system (for example, the safety circuit of an elevator control system). The third terminal XSES3 is connected to a 24-V SELV power supply. The second terminal XSES4 is connected to the frequency converter. The surge voltage suppression unit is configured to enhance the anti-interference capability of the input terminal of the safety electronic switch. The comparator has two functions: the first one is to detect an input voltage and start to drive a PhotoMOS optoelectronic coupler to operate when the input voltage reaches a set threshold; the second one is to reduce the influence of input voltage fluctuation in the safety circuit on SES by designing a threshold voltage through the comparator. The main function of the PhotoMOS optoelectronic coupler is to isolate an output. When the comparator drives the PhotoMOS optoelectronic coupler to operate, the switch of the PhotoMOS optoelectronic coupler is turned on to allow a 24-V voltage to be output, so as to enable the frequency converter. The input and the 24-V output of the safety circuit satisfy the requirements of safety electric isolation. In the elevator control system, the safety electronic switch is used to detect the on/off state of the safety circuit to enable the frequency converter, so as to control the elevator to operate safely and reliably.

At the input terminal, the high-impedance resistors and the transient voltage suppressors used in the surge voltage suppression unit function as limiting the surge voltage from being input to the control part of the circuitry. It is found through surge tests that when the input surge voltage reaches 2000 V, the voltage across the transient voltage suppressors D4 and D10 can be limited to be about 18 V. Therefore, the voltages of VCC1 and VCC2 are 18 V, and the operation of the line is not affected.

At the output terminal, the output voltages of STOA and STOB are in a range from 15 VDC to 30 VDC. After a PhotoMOS optoelectronic coupler is used, the surge breakdown voltage of the output terminal reaches 400 V, which is far higher than 15 VDC to 30 VDC as required in the safety specifications.

Through the analysis of the foregoing two points, the anti-interference capability of the safety electronic switch is much higher than its operating conditions, thus ensuring that the safety electronic switch can operate reliably in a complex electromagnetic environment.

In the present invention, the first terminal is used as an input terminal to be connected to the safety circuit of the control system, the second terminal is used as an output terminal to be connected to the frequency converter of the elevator, and the surge voltage suppression unit is used to enhance the anti-interference capability of the input terminal, thereby ensuring the reliability of operation in a complex electromagnetic environment. In addition, the influence of input voltage fluctuation on the circuit is reduced by designing a threshold voltage through the comparator. A dual-channel output structure is adopted to meet the requirements of the functional safety level SIL3. PhotoMOS optoelectronic couplers are used, which can not only meet the requirements of safety electric isolation, but also operate without noise and have a long service life. The input energy, and therefore the maximum input power, is limited by a high input impedance, thereby effectively limiting the temperature rise of the safety electronic switch, and improving the flame-retardancy of a product. Moreover, the flame-retardancy is further improved by using cement resistor as some of electric components and the PCB board, the terminals, and the housing being made of flame-retardant materials, and thereby ensuring the safety during operation.

In addition, the terminals with fault-tolerant design can effectively prevent the product from being damaged due to wiring errors during installation. LEDs are further disposed, making the operating status readily visible.

The foregoing descriptions are only preferred embodiments of the present invention and the present invention is not limited thereto. All technical solutions that use basically the same means to achieve the objective of the present invention shall fall within the protection scope of the present invention.

## Claims

1. A safety electronic switch, disposed between a safety circuit and a frequency converter and connected to an external low-voltage power supply to supply power, **characterized in that**, the safety electronic switch comprises: a first terminal, a second terminal, a third terminal, a surge voltage suppression unit, a comparator, and a relay, wherein an input terminal of the surge voltage suppression unit is connected to the safety circuit through the first terminal, the first terminal is provided with a live wire end and a neutral wire end, an output terminal of the surge voltage suppression unit is connected to an input terminal of the comparator, an output terminal of the comparator is connected to the relay, the relay is connected to the second terminal and the third terminal, respectively, the second terminal is connected to the frequency converter, the third terminal is connected to the low-voltage power supply, and the third terminal is provided with a positive electrode and a negative electrode that are connected to the low-voltage power supply.

2. The safety electronic switch according to claim 1, **characterized in that**,
- the surge voltage suppression unit comprises a transient voltage suppressor D4 and a transient voltage suppressor D10;
- one end of the transient voltage suppressor D4 is connected to the live wire end of the first terminal through a resistor R3 and a resistor R4 that are sequentially connected in series, and the other end of the transient voltage suppressor D4 is connected to the neutral wire end of the first terminal; and
- one end of the transient voltage suppressor D10 is connected to the live wire end of the first terminal through a resistor R14 and a resistor R13 that are sequentially connected in series, and the other end of the transient voltage suppressor D10 is connected to the neutral wire end of the first terminal.

3. The safety electronic switch according to claim 2, **characterized in that**, a resistor R7 is connected in parallel across the transient voltage suppressor D4, and a resistor R8 is disposed between the transient voltage suppressor D4 and the neutral wire end of the first terminal; and a resistor R17 is connected in parallel across the transient voltage suppressor D10, and a resistor R18 is disposed between the transient voltage suppressor D10 and the neutral wire end of the first terminal.

4. The safety electronic switch according to claim 2, **characterized in that**,
- the comparator comprises a first comparator and a second comparator, the first comparator comprises a comparator U2A and a comparator U2B, the second comparator comprises a comparator U4A and a comparator U4B, an anti-phase input terminal of the comparator U2A is connected to an anti-phase input terminal of the comparator U2B, an in-phase input terminal of the comparator U2A is connected to an in-phase input terminal of the comparator U2B, an anti-phase input terminal of the comparator U4A is connected to an anti-phase input terminal of the comparator U4B, and an in-phase input terminal of the comparator U4A is connected to an in-phase input terminal of the comparator U4B;
- a dual switching diode D3, a dual switching diode D6, a Zener diode D2, and a Zener diode D5 are disposed between the comparator U2A and the transient voltage suppressor D4; an output terminal of the comparator U2A is connected to a positive electrode of the Zener diode D2 and a negative electrode of the Zener diode D5, a negative electrode of the Zener diode D2 is connected to a negative electrode of the dual switching diode D3 and a negative electrode of the dual switching diode D6 through a resistor R2, an intermediate contact of the dual switching diode D3 is connected to a common terminal of the transient voltage suppressor D4 and the resistor R4, a capacitor C1 and a capacitor C2 are connected in parallel between a positive electrode and the negative electrode of the dual switching diode D3, a positive electrode of the Zener diode D5 is connected to a positive electrode of the dual switching diode D6 and the positive electrode of the dual switching diode D3, and an intermediate contact of the dual switching diode D6 is connected to the other end of the transient voltage suppressor D4; and a V+ terminal of the comparator U2A is connected to the negative electrode of the dual switching diode D3, the V+ terminal of the comparator U2A and a V+ terminal of the comparator U2B are both connected to a VCC1 terminal of the low-voltage power supply, a V- terminal of the comparator U2A is connected to the positive electrode of the dual switching diode D3 and the positive electrode of the dual switching diode D6, and the V- terminal of the comparator U2A and a V- terminal of the comparator U2B are both connected to a negative terminal of the capacitor C1; and
- a dual switching diode D9, a dual switching diode D12, a Zener diode D8, and a Zener diode D11 are disposed between the comparator U4A and the transient voltage suppressor D10, an output terminal of the comparator U4A is connected to a positive electrode of the Zener diode D8 and a negative electrode of the Zener diode D11, a negative electrode of the Zener diode D8 is connected to a negative electrode of the dual switching diode D9 and a negative electrode of the dual switching diode D12 through a resistor R12, an intermediate contact of the dual switching diode D9 is connected to a common terminal of the transient voltage suppressor D4 and the resistor R14, a positive electrode of the Zener diode D11 is connected to a positive electrode of the dual switching diode D12 and a positive electrode of the dual switching diode D9, and an intermediate contact of the dual switching diode D12 is connected to the other end of the transient voltage suppressor D10; and a capacitor C5 and a capacitor C6 are connected in parallel between the positive electrode and the negative electrode of the dual switching diode D9, a V+ terminal of the comparator U4A is connected to the negative electrode of the dual switching diode D9, the V+ terminal of the comparator U4A and a V+ terminal of the comparator U4B are both connected to a VCC2 terminal of the low-voltage power supply, a V-terminal of the comparator U4B is connected to the positive electrode of the dual switching diode D9 and the positive electrode of the dual switching diode D12, and a V- terminal of the comparator U4A and the V- terminal of the comparator U4B are both connected to a negative terminal of the capacitor C5.

5. The safety electronic switch according to claim 4, **characterized in that**,
- a common contact of the in-phase input terminal of the comparator U2A and the in-phase input terminal of the comparator U2B is connected to the positive electrode of the Zener diode D5 through a resistor R9, and the common contact of the in-phase input terminal of U2A and the in-phase input terminal of the comparator U2B is connected to the negative electrode of the Zener diode D2 through a resistor R6; and a common contact of the anti-phase input terminal of the comparator U2A and the anti-phase input terminal of the comparator U2B is connected to the positive electrode of the Zener diode D5 through a resistor R10, the common contact of the anti-phase input terminal of the comparator U2A and the anti-phase input terminal of the comparator U2B is connected to the V+ terminal of the comparator U2A through a resistor R5, the common contact of the anti-phase input terminal of the comparator U2A and the anti-phase input terminal of the comparator U2B is connected to the V- terminal of the comparator U2A through a capacitor C4, and the V+ terminal of the comparator U2B is connected to the V- terminal of the comparator U2B through a capacitor C3; and
- a common contact of the in-phase input terminal of the comparator U4A and the in-phase input terminal of the comparator U4B is connected to the positive electrode of the Zener diode D11 through a resistor R19, and the common contact of the in-phase input terminal of U4A and the in-phase input terminal of the comparator U4B is connected to the negative electrode of the Zener diode D8 through a resistor R16; and a common contact of the anti-phase input terminal of the comparator U4A and the anti-phase input terminal of the comparator U4B is connected to the positive electrode of the Zener diode D11 through a resistor R20, the common contact of the anti-phase input terminal of the comparator U4A and the anti-phase input terminal of the comparator U4B is connected to the V+ terminal of the comparator U4A through a resistor R15, the common contact of the anti-phase input terminal of the comparator U4A and the anti-phase input terminal of the comparator U4B is connected to the V- terminal of the comparator U4A through a capacitor C8, and the V+ terminal of the comparator U4B is connected to the V- terminal of the comparator U4B through a capacitor C7.

6. The safety electronic switch according to claim 4, **characterized in that**,
- the relay is selected as a PhotoMOS optoelectronic coupler, comprising a PhotoMOS optoelectronic coupler U1 and a PhotoMOS optoelectronic coupler U3, an STOA pin and an STOB pin connected to the frequency converter and used for dual outputs are disposed on the second terminal, and the third terminal is provided with the positive electrode and the negative electrode that are connected to the low-voltage power supply;
- a pin 4 of the PhotoMOS optoelectronic coupler U1 is connected to an output terminal of the comparator U2B, a pin 2 of the PhotoMOS optoelectronic coupler U1 is connected to a pin 3 of the PhotoMOS optoelectronic coupler U1, a pin 1 of the PhotoMOS optoelectronic coupler U1 is connected to the V+ terminal of the comparator U2B through a switching diode D1 and a resistor R1 that are sequentially connected in series, the pin 1 of the PhotoMOS optoelectronic coupler U1 is connected to a negative electrode of the switching diode D1, a positive electrode of the switching diode D1 is connected to the resistor R1, a pin 8 of the PhotoMOS optoelectronic coupler U1 is connected to the positive electrode of the third terminal, a pin 7 of the PhotoMOS optoelectronic coupler U1 is connected to a pin 6 of the PhotoMOS optoelectronic coupler U1, a pin 5 of the PhotoMOS optoelectronic coupler U1 is connected to the STOB pin of the second terminal, the pin 5 of the PhotoMOS optoelectronic coupler U1 is connected to the pin 8 of the PhotoMOS optoelectronic coupler U1 through a capacitor CY1, the pin 5 of the PhotoMOS optoelectronic coupler U1 is connected to a negative electrode of the second terminal through a resistor R21 and a light-emitting diode LED1 that are sequentially connected in series, a positive electrode of the light-emitting diode LED1 is connected to the resistor R21, a negative electrode of the light-emitting diode LED1 is connected to the negative electrode of the second terminal, a diode D15 is connected in parallel across the light-emitting diode LED1, the positive electrode of the light-emitting diode LED1 is connected to a negative electrode of the diode D15, and the negative electrode of the light-emitting diode LED1 is connected to a positive electrode of the diode D15; and
- a pin 4 of the PhotoMOS optoelectronic coupler U3 is connected to an output terminal of the comparator U4B, a pin 2 of the PhotoMOS optoelectronic coupler U3 is connected to a pin 3 of the PhotoMOS optoelectronic coupler U3, a pin 1 of the PhotoMOS optoelectronic coupler U3 is connected to the V+ terminal of the comparator U4B through a switching diode D7 and a resistor R11 that are sequentially connected in series, the pin 1 of the PhotoMOS optoelectronic coupler U3 is connected to a negative electrode of the switching diode D7, a positive electrode of the switching diode D7 is connected to the resistor R11, a pin 8 of the PhotoMOS optoelectronic coupler U3 is connected to the positive electrode of the third terminal, a pin 7 of the PhotoMOS optoelectronic coupler U3 is connected to a pin 6 of the PhotoMOS optoelectronic coupler U3, a pin 5 of the PhotoMOS optoelectronic coupler U3 is connected to the STOA pin of the second terminal, the pin 5 of the PhotoMOS optoelectronic coupler U3 is connected to the pin 8 of the PhotoMOS optoelectronic coupler U3 through a capacitor CY2, the pin 5 of the PhotoMOS optoelectronic coupler U3 is connected to the negative electrode of the second terminal through a resistor R22 and the light-emitting diode LED2 that are sequentially connected in series, a positive electrode of the light-emitting diode LED2 is connected to the resistor R22, a negative electrode of the light-emitting diode LED2 is connected to the negative electrode of the second terminal, a diode D16 is connected in parallel across the light-emitting diode LED2, the positive electrode of the light-emitting diode LED2 is connected to a negative electrode of the diode D16, and the negative electrode of the light-emitting diode LED2 is connected to a positive electrode of the diode D16.

7. The safety electronic switch according to claim 1, **characterized in that**, a diode D13, a transient voltage suppressor D14, and a diode D17 that are sequentially connected in series are disposed between the positive electrode and the negative electrode of the third terminal, the positive electrode of the third terminal is connected to a positive electrode of the diode D13, a negative electrode of the diode D13 is connected to a negative electrode of the transient voltage suppressor D14, a positive electrode of the transient voltage suppressor D14 is connected to a positive electrode of the diode D17, and a negative electrode of the diode D17 is connected to the negative electrode of the third terminal; and a common terminal of the diode D13 and the transient voltage suppressor D14 is connected to a positive electrode of the low-voltage power supply.

8. The safety electronic switch according to claim 1, **characterized in that**, the live wire end of the first terminal is set to be a pin 1, and the neutral wire end is set to be a pin 4; and the positive electrode of the third terminal is set to be a pin 2, and the negative electrode is set to be a pin 3.

9. The safety electronic switch according to claim 6, **characterized in that**, the STOB pin of the second terminal is set to be a pin 1, the STOA pin is set to be a pin 3, a negative electrode of a low voltage power supply and a PE pin are further comprised, the negative electrode of the low voltage power supply is set to be a pin 2, and the PE pin is set to be a pin 4.

10. The safety electronic switch according to claim 2, **characterized in that**, further comprising a flame-retardant housing and a flame-retardant PCB board disposed inside the flame-retardant housing, the first terminal, the second terminal, the third terminal, the surge voltage suppression unit, the comparator, and the relay are all packaged on the flame-retardant PCB board, and the resistor R3, the resistor R4, the resistor R13, and the resistor R14 are all selected as cement resistor.
